# EUROPEAN PATENT SPECIFICATION

(11) **EP 0 431 887 B1**
(45) Date of publication and mention of the grant of the patent: **06.09.1995**
(21) Application number: 90313141.5
(22) Date of filing: 04.12.1990
(51) Int. Cl.: H03L 1/02

(54) **Variable capacitance capacitor array**
Kondensatorenanordnung mit variabler Kapazität
Réseau de condensateurs à capacité variable

(30) Priority: 05.12.1989 JP 316205/89
(43) Date of publication of application: 12.06.1991
(73) Proprietor: SEIKO EPSON CORPORATION, Shinjuku-ku Tokyo (JP)
(72) Inventor: Imamura, Yoichi, Suwa-shi, Nagano-ken (JP)
(74) Representative: Kenyon, Sarah Elizabeth

(56) References cited:
- EP-A- 0 133 388
- PATENT ABSTRACTS OF JAPAN vol. 11, no. 277 (E-538)(2724) September 8, 1987 & JP-A-62 76 801 (NEC CORP ) April 4, 1987
- PATENT ABSTRACTS OF JAPAN vol. 11, no. 292 (E-543)(2739) September 19, 1987 & JP-A-62 91 006 (MATSUSHIMA KOGYO CO LTD ) April 25, 1987
- PATENT ABSTRACTS OF JAPAN vol. 12, no. 330 (E-655)(3177) September 7, 1988 & JP-A-63 93 205 (MATSUSHIMA KOGYO CO LTD ) April 4, 1988
- PROCEEDINGS OF THE IEEE 1989 CUSTOM INTEGRATED CIRCUITS CONFERENCE,MAY 15-18, PAGES 1611-1615, NEW YORK, U.S.A. ROESGEN AND WARREN: "AN ANALOG FRONT END CHIP FOR V.32 MODEMS".

## Description

This invention concerns a capacitor array arranged for providing a variable capacitance, and particularly a high accuracy temperature compensating liquid crystal oscillator circuit having such a capacitor array for adjusting the frequency of the oscillator output.

Japanese Laid Open Patent Application No. 62-76801 describes a temperature compensating liquid crystal oscillator circuit having a capacitor array, in which the output from a memory containing temperature compensation data is converted into parallel form and is then given a large time co-efficient by a charge/discharge circuit for controlling the switching of capacitors into and out of the array. This arrangement attempts to improve the purity of the oscillator output (C/N ratio).

However, with currently available technology, it is difficult to fabricate charge/discharge circuits having large time co-efficients in a semi-conductor integrated circuit. In addition, high level accuracy requires that each individual capacitor of the capacitor array becomes smaller, where-upon the number of capacitors is increased. With an increase in the number of capacitors, the parasitic capacitance of the switching elements relative to the capacitance of the capacitors attains a level that cannot be ignored, and the ratio of the capacitance of the capacitors and the parasitic capacitance of the switching elements becomes very small. As a result, it becomes difficult to adjust the oscillating frequency over a broad range. Further, if the number of capacitors is increased, the capacity of the memory for the temperature compensation data also has to be increased, which involves greater cost.

It is an object of the present invention, at least in its preferred form, to overcome such problems.

According to the present invention, a capacitor array for providing a variable capacitance, having a plurality of switching elements, each for switching a respective capacitor in the array ON and OFF, and means for controlling switching of the switching elements to switch selected ones of the capacitors ON or OFF, whereby the capacitance is varied, the control means being arranged to co-operate with voltage generation means so as to supply to a control electrode of each switching element for switching a selected capacitor an ON voltage or an OFF voltage which causes the impedance provided by the switching element to change between ON and OFF levels, is characterised in that the control means and the voltage generation means co-operate so as to supply to the control electrode of each switching element for switching a selected capacitor at least a further voltage which causes the impedance provided by the switching element to change from an ON or OFF level to an intermediate level before changing to an OFF or ON level.

As a result of the above structure, semi-continuous switching of the switching elements between their on and off conditions (and hence intermediate impedance) may be attained. Therefore, the electrical potential of the capacitor electrodes will not make sudden changes and smooth capacitor switching is possible.

Advantageously, the capacitor array according to the invention requires little switching, but has a substantial on/off capacitance ratio. And, when employed in a temperature compensating liquid crystal oscillator circuit, the invention advantageously allows fine adjustment with only a small memory capacity.

The invention is described further, by way of example, with reference to the accompanying drawings, in which:-
Figure 1 is a block diagram showing a crystal oscillator circuit having a capacitor array for providing a variable capacitance according to this invention;
Figure 2 is a circuit detail showing an equivalent circuit for the capacitor array of the crystal oscillator circuit of Figure 1;
Figure 3 is a graph showing the change in equivalent capacitance in relation to the gate potential of a respective switching element; and
Figure 4 is a diagram showing a specific circuit example of the crystal oscillator circuit of Figure 1.

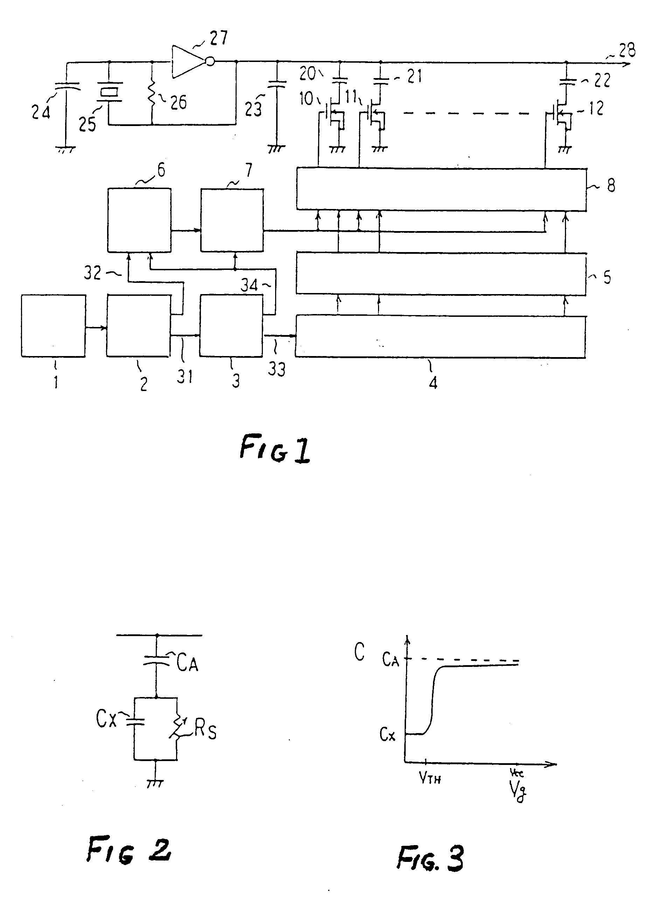

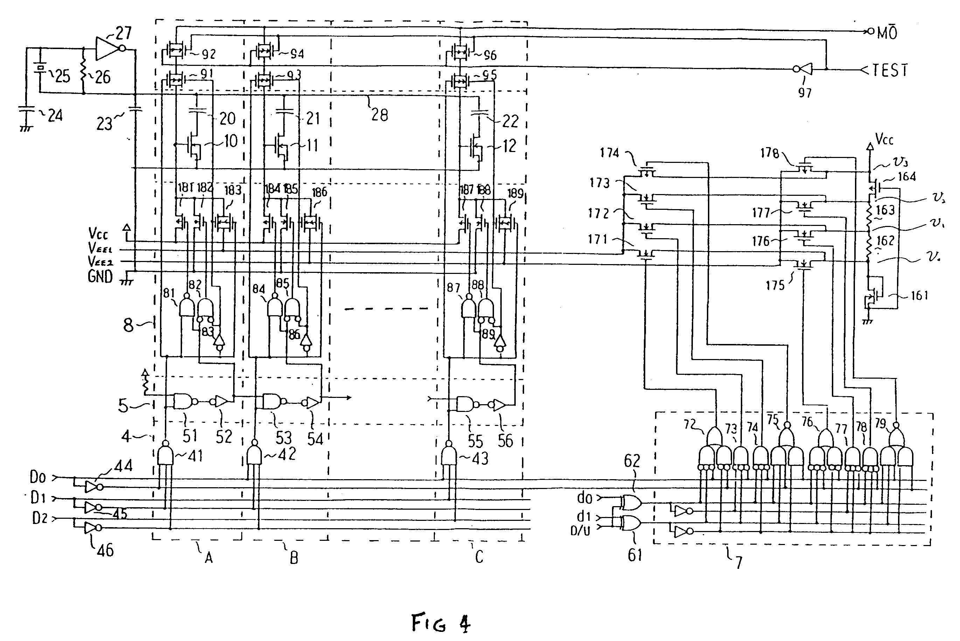

Figure 1 is a circuit diagram of a crystal oscillator circuit showing the use of a capacitor array for providing a variable capacitance for stabilising the output of the oscillator. A specific example of the circuit is shown in Figure 4, wherein the same circuit elements have been given the same numbers. The example of Figure 4 is based on a semi-conductor integrated circuit that uses complementary MOS (CMOS) transistors but the invention is not limited to such technology.

As shown, the crystal oscillator circuit comprises a crystal vibrator 25 connected between the gate and the drain of an oscillation amplifier 27. In addition, connected to the drain line 28 are a fixed capacitor 23 and a capacitor array comprising capacitors 20, 21 and 22. The capacitors in the array are connected respectively with the ground by way of FET switches 10, 11 and 12, which are arranged to be switched on and off via signals from a switching control circuit 8 so as to vary the overall capacitance value. Where this invention differs greatly from technology to date is in providing a number of electrical potentials through a D/A converter 7 to the gates of the FET switches 10, 11 and 12 for controlling the associated capacitors.

More especially, the output of a temperature sensor 1 passes through some sort of A/D converter 2 in order to obtain digitised temperature data. The most significant bits 31 of the output of this A/D converter 2 are input as an address signal to the memory circuit 3, which stores temperature compensation data. The least significant bits 32 of the output of the A/D converter 2 are input to the D/A converter 7 through a reversing circuit 6. The output 33 of the memory circuit 3 passes through a (BCD) decoder 4 and is provided to a linear converter 5. In order to reduce the amount of memory capacity, the memory circuit 3 memorises the compensation data for each compensated temperature in binary code. In response to this data, selected outputs of the decoder 4 enter an active status. If, in the case of the decoder 4 or the linear converter 5, the output 33 is equal to the output of the decoder 4 or the linear converter 5 in Figure 1, that circuit may be omitted. If a respective FET switch is directly turned on and off by means of the output of the decoder 4, it is necessary for the associated capacitor to take on a weighted capacitance value. However, the invention has been designed so that weighting control can take place even when a linear converter 5 is employed and even if the capacitance of each capacitor in the array is equal. In this way, the total capacitance value of the capacitor array can be minimised and low level uniformity of switching noise and a greater degree of freedom of compensation become possible.

The output of the D/A converter 7 is interpolated to an intermediate value of a range for providing compensation according to the output of the linear converter 5 through the switching control circuit 8. In this invention, when intermediate interpolation takes place, the result is that the FET-on resistance changes and this changes the CR time constant between the drain line 28 and the ground.

Referring now to Figure 4, signals D0, D1 and D2, signals d0 and d1, and signals D/u correspond to the output 33, the output 32 and the output 34, respectively, in Figure 1. It is possible to increase and decrease the number of bits for the outputs 33 and 32.

The switching of the capacitor array takes place on the basis of a combination of the output of the 3-bit-input decoder 4 and the output of the D/A converter 7. The output of the decoder 4 is supplied to the linear converter 5, where conversion takes place so that the boundary between the capacitors in the array which are turned on and those which are turned off is always one that corresponds with the physical position of the respective capacitor 10, 11 or 12 in the array. In other words, a respective output of the decoder 4 will be L (and the others will be H) according to the inputs D0 to D2 and, when this output is supplied to the linear converter 5 at a location in the figure corresponding to a particular capacitor at that boundary, that capacitor and the capacitor on the left will turn on (be connected to ground) and the capacitor on the right will turn off.

As previously stated, the input of the decoder 4 is supplied from the temperature sensor 1 by way of the A/D converter 2. For example, the temperature sensor may be in the form of a crystal oscillator or a semi-conductor sensor whose output is passed through the A/D converter, which may comprise a voltage-frequency converter, for converting to a digital value. The most significant bits of the digital output of the converter 2 are provided as the address signal 31 to the memory circuit 3 (ROM) in which the temperature compensation data has been stored. The least significant bits 32 (d0 and d1) are provided as the input of the D/A converter 7. Because the least significant bits 32 represent a secondary or a tertiary curve of the crystal vibrator temperature characteristics, in order to provide a smooth compensation at the points of inflection, it is necessary to reverse the sequence of the least significant bits. This is achieved by supplying the signals d0 and d1 to the D/A converter 7 through the reversing circuit 6. The reverse control signal D/u supplied to the reversing circuit 6, which is composed of EX-OR gates 61 and 62, is obtained or calculated from the output of the memory circuit 3.

In Figure 4, each of the circuits 4, 5 and 8 for controlling the capacitor array is formed as a plurality of regular circuit units, as indicated by the broken lines A, B and C. The unit B will be explained below. The switch control circuit 8, which is composed of control gates 84, 85 and 86 and transfer gates in the form of transistors 184, 185 and 186, receives the output of the decoder 4 and linear converter 5, composed of decoder 42 and gates 53 and 54, and controls the gate potential of the FET switch 11, which is an N-channel MOS transistor. The switch control circuit 8 is composed of the three transfer gates for transmitting the off electrical potential (ground), the on electrical potential (V_{cc}) and an intermediate electrical potential VEE2 between the off potential and the on potential, and the control gates for these three transfer gates. When the output of the decoder 4 is L (active), the intermediate potential VEE2, which is provided by the D/A converter 7, is transferred. In the unit A on the left hand side of the unit B, the on electrical potential will be transferred by means of the transfer gate 181. In the unit C on the right hand side, the off electrical potential, common ground, will be transferred by means of the transfer gate 188.

As a result of this, and because the FET switches 10, 11 and 12 operate as variable resistances in this invention, the equivalent circuit for each capacitor of the array becomes as shown in Figure 2. In this diagram, Cx is the parasitic capacitance of the associated switch, Rs is the FET switch resistance and CA is the capacitance of the relevant capacitor. Because the equivalent capacitance C seen from the drain line 28 can be expressed as:$\text{C =} \frac{\text{CA x (Cx +} \frac{\text{1}}{\text{Rs}} \text{)}}{\text{CA + Cx +} \frac{\text{1}}{\text{Rs}}}$
and because for a FET gate potential Vg$\text{Rs ∝} \frac{\text{1}}{\text{Vg}}$
the relationship shown in Figure 3 exists.

Here, it is noteworthy that the equivalent capacitance C changes abruptly in the vicinity of the threshold voltage VTH of the FET switch. Therefore, if the FET switch is controlled with a simple time constant circuit, this will cause a sudden change in the equivalent capacitance C. The electrical potential of the drain line 28 will then change abruptly and switching caused by capacitor coupling will be generated on the drain line 28, as described in Japanese Patent Application No. 62-76801. For this reason, in this invention, a gate voltage is generated in the region of the equivalent capacitance C shown in Figure 3 that undergoes the sudden change, using the D/A converter 7 in Figure 1. In Figure 4, a MOS transistor 161 that has the same channel length as each of the FET switches is made to operate at a constant current with a voltage close to the threshold voltage. An electrical potential v0 is used as its gate voltage and electrical potentials v1 and v2, which are slightly higher, are generated from the electrical potential v0 using passive resistances 162 and 163, which are either diffused resistances or polysilicon resistances. A maximum electrical potential v3 is set to be close to the power supply voltage V_{cc}.

Electrical potentials v0 to v3 are selected by analog switches 171 to 178 under the control of the D/A converter 7 and supplied to the respective transfer gates 183, 186 and 189 as intermediate electrical potentials VEE1 and VEE2. During the switching on of each FET switch 10, 11 and 12, the output of the D/A converter passes through four different states, in response to the different combinations of the signals d0 and d1 supplied to the reversing circuit 6. Accordingly, the electrical potential VEE1 or VEE2 changes from v0 to v3 in steps for switching the relevant FET switch on. Since the electrical potential v0 to v3 are generated through high resistances, they are supplied to the gate of the FET switch with a large time constant and hence semi-continuous switching of the FET switch effectively occurs and the equivalent capacitance can change more smoothly.

When the switching of the capacitor array shifts so that a FET switch, which has received the on electrical potential V_{cc}, is to be turned off, the voltage VEE1 or VEE2 would change abruptly from v3 to v0. Thus, there could be a situation in which, for an instant, the gate potential of the FET switch is made to fluctuate wildly through the transfer gate 183, 186 or 189. In order to prevent this, in the present invention, two lines for the voltages VEE1 and VEE2 are provided and the D/A converter 7 and analog switches 171 to 178 are divided into two voltage generating portions, one for generating a rising intermediate electrical potential and one for generating a falling intermediate electrical potential. Thus, the logic of the D/A converter 7 is configured so as to cause the intermediate electrical potential to change in steps on the one hand from v0 to v3 and on the other hand from v3 to v0.

The testing of the described capacitor array switching circuit cannot generally be performed sufficiently with an LSI tester. However, in this invention, transfer gates 91 to 96, which are turned on and off by the output of the decoder 4 and the linear converter 5 and a test signal TEST, are provided for each unit of the array so that the gate potential of the FET switches can be monitored from a monitor pin MO̅. Only those units for which the output of the decoder 4 is active will be selected for output of the gate potential at the MO̅ pin. In this way, the operation of the circuit that controls the FET switches is definitely testable, allowing the realisation of a highly reliable capacitor array.

As described above, because the capacitance of the capacitor array changes very smoothly, an oscillation circuit using the array will not suffer the sudden frequency fluctuations caused by switching, making it possible to provide an extremely pure oscillation output. In addition, compared to other technology to date, high resolution fine adjacent may be realised because a significant reduction in the number of capacitors is possible while still giving a comparatively large capacitance. Thus, the ratio of parasitic capacitance Cx in Figure 2 can be reduced, allowing a wider range of frequencies for the oscillation circuit. Moreover, the large area taken up by the capacitors on the surface of the semi-conductor integrated circuit can be reduced and the memory capacity needed for compensation can also be reduced, whereby the realisation of lower cost variable capacitance array integrated circuits is possible.

In the described example, the capacitor array is on the output side of the oscillation amplifier. However, it goes without saying that the array could be fabricated on the input side or both the input side and the output side. In addition, the invention is not limited to oscillator circuits. It can be applied widely in applications where capacitors are employed, for example in filters and tuning devices and in applications that use time constants, as well as in electronic circuits that require fine programmable adjustments in capacitance.

## Claims

1. A capacitor array for providing a variable capacitance, having a plurality of switching elements (10, 11 ... 12), each for switching a respective capacitor (20, 21 ... 22) in the array ON and OFF, and means (8) for controlling switching of the switching elements to switch selected ones of the capacitors ON or OFF, whereby the capacitance is varied, the control means (8) being arranged to co-operate with voltage generation means (7) so as to supply to a control electrode of each switching element for switching a selected capacitor an ON voltage or an OFF voltage which causes the impedance provided by the switching element to change between ON and OFF levels, characterised in that the control means (8) and the voltage generation means (7) co-operate so as to supply to the control electrode of each switching element for switching a selected capacitor at least a further voltage which causes the impedance provided by the switching element to change from an ON or OFF level to an intermediate level before changing to an OFF or ON level.

2. An array according to claim 1, characterised in that at least two further voltages are supplied by the co-operation of the control means (8) and the voltage generation means (7) to cause the impedance provided by the switching element to change between a plurality of intermediate levels between ON and OFF levels, and in that the order in which the further voltages are supplied is controlled by the control means (8) for changing from an ON level and that order is reversed by the control means (8) for changing from an OFF level.

3. An array according to claim 1 or 2, characterised in that the switching elements (10, 11 ...12) the capacitors (20, 21 ...22) and the control means (8) are connected to provide similar units, each containing a pre-determined number of the switching elements, a pre-determined number of capacitors and a pre-determined portion of the control means.

4. An array according to any preceding claim, characterised by means (2) for receiving a control input and for supplying a digital output, in which the least significant bit or bits are applied to the voltage generation means for selectively determining the voltage .

5. An array according to claim 4, characterised in that the control means (8) are arranged to co-operate with the voltage generation means (7) such that the impedance of only two of the switching elements is changed in response to a change in the least significant bit of the digital output.

6. An array according to any preceding claim, characterised by means (91 to 96) for supplying the voltage at the control electrode of each switching element for switching on a selected capacitor to a monitoring pin (MO̅) for testing purposes.

## Patentansprüche

1. Kondensatoranordnung zum Bereitstellen einer variablen Kapazität, mit einer Mehrzahl von Schaltelementen (10, 11...12), von denen jedes zum EIN- und AUS-Schalten je eines Kondensators (20, 21...22) in der Anordnung vorgesehen ist, und mit Mitteln (8), um das Schalten der Schaltelemente so zu steuern, daß ausgewählte der Kondensatoren EIN- oder AUS-geschaltet werden, wodurch die Kapazität geändert wird, wobei die Steuermittel (8) zum Zusammenwirken mit Spannungserzeugungsmitteln (7) ausgebildet sind, um einer Steuerelektrode jedes Schaltelements zum Schalten eines ausgewählten Kondensators eine EIN-Spannung oder eine AUS-Spannung zu liefern, welche bewirkt, daß sich die durch das Schaltelement vorgesehene Impedanz zwischen EIN- und AUS-Niveaus ändert,
**dadurch gekennzeichnet**,
daß die Steuermittel (8) und die Spannungserzeugungsmittel (7) dergestalt zusammenwirken, der Steuerelektrode jedes Schaltelements zum Schalten eines ausgewählten Kondensators wenigstens eine weitere Spannung zu liefern, welche bewirkt, daß sich die durch das Schaltelement vorgesehene Impedanz von einem EIN- oder AUS-Niveau auf ein Zwischenniveau ändert, bevor die Änderung auf ein AUS- oder EIN-Niveau erfolgt.

2. Anordnung nach Anspruch 1,
dadurch gekennzeichnet, daß durch das Zusammenwirken der Steuermittel (8) und der Spannungserzeugungsmittel (7) wenigstens zwei weitere Spannungen geliefert werden, um zu bewirken, daß sich die durch das Schaltelement vorgesehene Impedanz zwischen einer Mehrzahl von Zwischenniveaus zwischen EIN- und AUS-Niveaus ändert, und daß die Reihenfolge, in der die weiteren Spannungen geliefert werden, durch die Steuermittel (8) für eine Änderung von einem EIN-Niveau gesteuert wird und für eine Änderung von einem AUS-Niveau diese Reihenfolge durch die Steuermittel (8) umgekehrt wird.

3. Anordnung nach Anspruch 1 oder 2,
dadurch gekennzeichnet, daß die Schaltelemente (10, 11...12), die Kondensatoren (20, 21...22) sowie die Steuermittel (8) so geschaltet sind, daß sie ähnliche Einheiten bilden, von denen jede eine vorbestimmte Anzahl der Schaltelemente, eine vorbestimmte Anzahl von Kondensatoren und einen vorbestimmten Teil der Steuermittel enthält.

4. Anordnung nach einem der vorhergehenden Ansprüche,
gekennzeichnet durch Mittel (2), um eine Steuereingabe zu empfangen und eine digitale Ausgabe zu liefern, bei welcher zur selektiven Bestimmung der Spannung das niedrigstwertige Bit oder die niedrigstwertigen Bits an die Spannungserzeugungsmittel angelegt werden.

5. Anordnung nach Anspruch 4,
dadurch gekennzeichnet, daß die Steuermittel (8) zu solchem Zusammenwirken mit den Spannungserzeugungsmitteln (7) ausgebildet sind, daß in Antwort auf eine Änderung des niedrigstwertigen Bits der digitalen Ausgabe die Impedanz von nur zweien der Schaltelemente geändert wird.

6. Anordnung nach einem der vorhergehenden Ansprüche,
gekennzeichnet durch Mittel (91 bis 96), um zu Testzwecken die Spannung an der Steuerelektrode jedes Schaltelements zum Einschalten eines ausgewählten Kondensators an einen Überwachungsanschluß (MO̅) zu liefern.

## Revendications

1. Réseau de condensateur pour former une capacité variable, comprenant une pluralité d'éléments de commutation (10, 11 ... 12) destinés chacun à commuter un condensateur correspondant (20, 21 ... 22) du réseau sur MARCHE et ARRET, et des moyens (8) pour commander la commutation des éléments commutateurs et commuter les condensateurs choisis sur MARCHE ou ARRET, de façon à faire varier la capacité, les moyens de commande (8) étant agencés pour coopérer avec des moyens générateurs de tension (7) de manière à appliquer à une électrode de commande de chaque élément de commutation d'un condensateur sélectionné, une tension MARCHE ou une tension ARRET qui fait varier l'impédance présentée par l'élément de commutation entre des niveaux de MARCHE et d'ARRET, caractérisé en ce que les moyens de commande (8) et les moyens générateurs de tension (7) coopèrent pour appliquer à l'électrode de commande de chaque élément de commutation d'un condensateur sélectionné au moins une autre tension qui fait passer l'impédance présentée par l'élément de commutation du niveau MARCHE ou du niveau ARRET jusqu'à un niveau intermédiaire avant de passer à un niveau d'ARRET ou de MARCHE.

2. Réseau selon la revendication 1, caractérisé en ce que deux autres tensions au moins sont appliquées par l'association des moyens de commande (8) et des moyens générateurs de tension (7) pour faire varier l'impédance présentée par l'élément de commutation entre une pluralité de niveaux intermédiaires entre les niveaux de MARCHE et d'ARRET, et en ce que l'ordre dans lequel les autres tensions sont appliquées est commandé par les moyens de commande (8) lorsque le changement se fait à partir d'un niveau de marche et en ce que cet ordre est inversé par les moyens de commande (8) lorsque le changement se fait à partir d'un niveau d'ARRET.

3. Réseau selon la revendication 1 ou 2, caractérisé en ce que les éléments de commutation (10, 11 ... 12), les condensateurs (20, 21 ... 22) et les moyens de commande (8) sont connectés pour constituer des unités semblables dont chacune comprend un nombre prédéterminé d'éléments de commutation, un nombre prédéterminé de condensateurs et une partie prédéterminée des moyens de commande.

4. Réseau selon l'une quelconque des revendications précédentes, caractérisé par des moyens (2) pour recevoir une entrée de commande et délivrer une sortie numérique, dans lequel le ou les bits de plus faible poids sont appliqués aux moyens générateurs de tension pour déterminer sélectivement la tension.

5. Réseau selon la revendication 4, caractérisé en ce que les moyens de commande (8) sont agencés pour coopérer avec les moyens générateurs de tension (7) de manière que l'impédance de deux seulement des éléments de commutation soient modifiés en réponse à un changement du bit de plus faible poids de la sortie numérique.

6. Réseau selon l'une quelconque des revendications précédentes, caractérisé par des moyens (91 à 96) pour appliquer la tension de l'électrode de commande de chaque élément de commutation destiné à commuter en marche un condensateur sélectionné, à une broche de surveillance (M O̅) à des fins de contrôle.
